# EUROPEAN PATENT APPLICATION

(11) **EP 0 670 667 A1**
(43) Date of publication of application: **06.09.1995**
(21) Application number: 95300788.7
(22) Date of filing: 08.02.1995
(51) Int. Cl.: H05K 1/02, H01L 23/15

(54) **Direct copper bonded substrates**

(30) Priority: 24.02.1994 GB 9403520
(71) Applicant: PLESSEY SEMICONDUCTORS LIMITED, Swindon, Wiltshire SN2 2QW (GB)
(72) Inventor: Dickenson, Robert James, Lincoln LN5 9HG (GB)
(74) Representative: Hoste, Colin Francis

(57) **Abstract**

In a direct copper bonded substrate arrangement having copper layers on both major surfaces of an electrically insulating substrate, one of which layers is patterned to leave a gap, the copper of the other layer is reduced in section over a region opposite the gap so as to reduce the cross-section of copper in tension across the gap, and thereby the forces which would tend to distort the substrate as a result of temperature cycling.

## Description

Direct copper bonded (DCB) substrates consist of an isolator of insulating material sandwiched between two layers of copper, all of which can vary in thickness dependant upon the application. The process by which DCB substrates are made involves temperatures of around 1000 °C. This results in a near melt of the copper. Since the insulating material is usually Alumina or Aluminium Nitride a resultant mismatch in expansion is inevitable.

As the DCB substrate assembly cools an interaction takes place between the copper and the isolator producing a high strength bond between the two. As cooling continues the copper shrinks more than the isolator resulting in tension-in the copper and compression in the isolator. However, the copper does not regain its original dimensions.

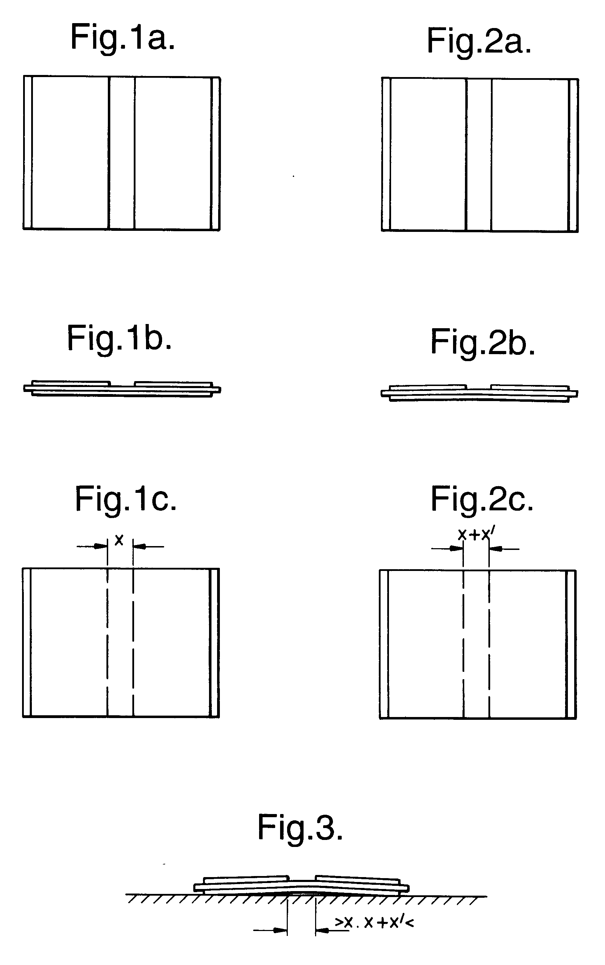

If a DCB substrate has an equal amount of copper on both sides the stresses are matched symmetrically through the centre of the isolator and little distortion takes place. However, DCB substrates are patterned or discontinuous on one or both sides for a variety of applications. Unless the pattern is identical on both sides the stresses in the material are no longer symmetrical, resulting in distortion, usually manifesting itself as "bowing", as shown in Figures 1 and 2.

Straight after manufacture the copper on the isolator is very soft, or fully annealed. If a DCB substrate is manufactured using different patterns or patterns are etched subsequent to removal from the process furnace the above mentioned distortion will be detected. If the patterned DCB substrate is then kept at constant temperature the distortion will remain constant. However, any variation in temperature causes the copper to expand or contract, depending on the pattern this will cause the DCB substrate assembly to flex. Since DCB substrates may be used as electrically isolating but thermally conducting interfaces between electrical components and heat sinks many temperature variations are inevitable, both from manufacturing processes such as soldering and those associated with service.

Continual flexing of the substrate due to differential expansion and patterning causes the copper to work harden and the tension in it to increase. Such increase in tension results in more distortion which may be so severe as to cause the isolating material to fail. In an electrical assembly the distortion may cause the substrate to move away from its heat sink surface as shown in Figure 3, resulting in component failure due to poor heat transfer.

Such distortion due to the above effects can be dramatically reduced, the most effective method being to ensure equal patterns on both sides as previously mentioned. However, since the isolating material tends to be brittle, removing copper on both sides in identical positions results in a weak unprotected area very susceptible to failure.

According to the present invention in a direct copper bonded substrate comprising a substantially laminar substrate of electrically insulating material having a layer of copper on each major surface thereof, the layer of copper on one of said major surfaces being patterned such that at least one area thereof is omitted or removed, the layer of copper on the other of said major surfaces is reduced in cross-section over a region opposite said at least one area.

A direct copper bonded substrate in accordance with the present invention will now be described by way of example with reference to the accompanying drawings, of which:-
Figures 1 to 3 illustrate known direct copper bonded substrates,
Figure 4 shows a direct copper bonded substrate in accordance with the invention, and
Figure 5 illustrates the level of distortion obtaining in known substrates compared with the level in a substrate in accordance with the present invention.

Referring to the drawings, Figure 1 illustrates a DCB substrate prior to the bonding operation, Figure 1(a) showing the "patterned" side, Figure 1(b) showing the cross-section and Figure 1(c) showing a plain copper layer, the dimension X indication the separation of two notional lines in the plain copper layer lying directly opposite the edges of the patterned layer.

Figure 2 shows the substrate after bonding where, because of the difference in expansion coefficients the dimension X in the plain copper layer has not returned to its original value upon cooling, and slight distortion may be detected.

Figure 3 shows the effects of temperature cycling of the substrate, when repeated expansion and contraction of the copper in the region opposite the gap on the patterned surface results in the copper in that region work hardening and increasing the tension and thus exaggerating the distortion. The areas covered by continuous copper layers on either side are not affected and remain flat and parallel.

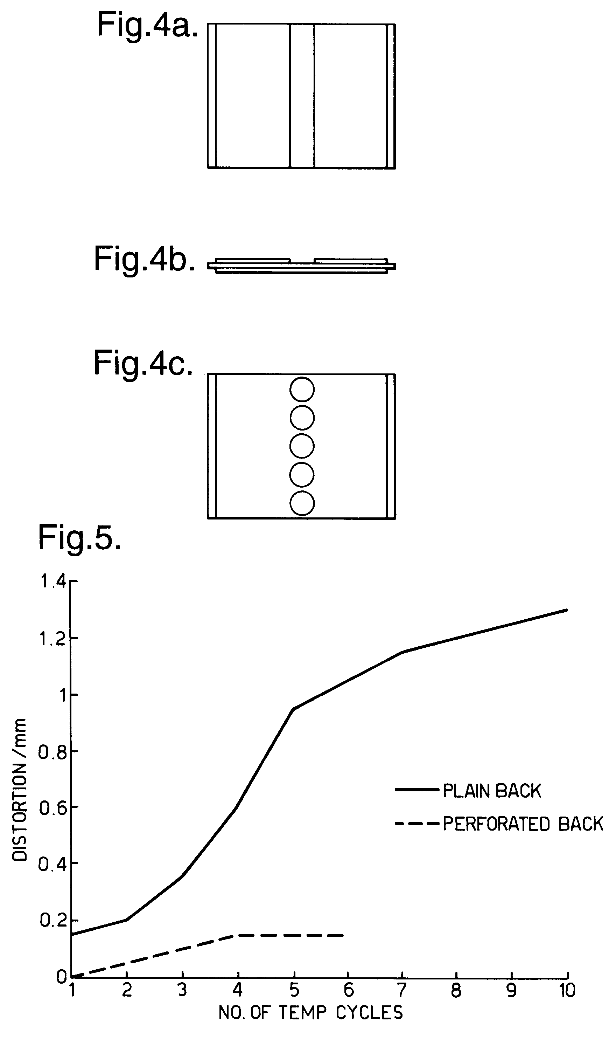

In Figure 4 the "plain" copper layer is shown with a series of perforations along the region opposite the gap in the patterned layer, these perforations reducing the cross-section of the copper in tension across the gap and thus reducing the force causing distortion. The perforations may be circular in plan view, as shown in Figure 4, or may be in the form of slots in the copper layer extending substantially across the gap. The copper cross-section across the gap could of course be reduced in other ways, provided some fairly evenly distributed copper remains to protect the relatively weak substrate.

The effect of reducing the cross-section of copper in the plain copper layer can be seen from Figure 5, which shows the results of a comparative test between two substrates, one with plain copper opposite the gap in the patterned layer and the other with perforations to reduce the cross-sectional area in tension opposite the gap.

The reduction in distortion improves the reliability of any structure using such a direct copper bonded substrate in a situation subject to temperature variations.

## Claims

1. A direct copper bonded substrate comprising a substantially laminar substrate of electrically insulating material having a layer of copper on each major surface thereof, the layer of copper on one of said major surfaces being patterned such that at least one area thereof is omitted or removed, wherein the layer of copper on the other of said major surfaces is reduced in cross-section over a region opposite said at least one area.

2. A direct copper bonded substrate in accordance with Claim 1 wherein the layer of copper on the other of said major surfaces is reduced in cross-section over said region by means of a series of perforations through said layer.

3. A direct copper bonded substrate in accordance with Claim 2 wherein said perforations are circular in section.

4. A direct copper bonded substrate substantially as hereinbefore described with reference to Figure 4 of the accompanying drawings.
